# EUROPEAN PATENT APPLICATION

(11) **EP 4 567 971 A1**
(43) Date of publication of application: **11.06.2025**
(21) Application number: 24815863.6
(22) Date of filing: 30.05.2024
(51) Int. Cl.: H01M 10/6556, H01M 10/6554, H01M 10/613

(54) **HEAT SINK ASSEMBLY**

(30) Priority: 02.06.2023 KR 20230071942
(71) Applicant: LG Energy Solution, Ltd., Seoul 07335 (KR)
(72) Inventor: HAN, Nyeon Gu, Daejeon 34122 (KR); LEE, Hyoung Suk, Daejeon 34122 (KR); HUR, Nam Hoon, Daejeon 34122 (KR); KIM, Ki Young, Daejeon 34122 (KR); KIM, Young Man, Daejeon 34122 (KR)
(74) Representative: Plasseraud IP
(86) International application number: PCT/KR2024/007360
(87) International publication number: WO 2024/248488

(57) **Abstract**

A heat sink assembly including a heat sink having a plurality of flow paths integrally formed along a length direction, the spaces between the flow paths forming a solid part, a first surface and a second surface of both ends in the length direction are opened, and both ends of the flow paths are spaced apart from the first surface and the second surface, and end plugs closing the opened first surface and second surface of both ends of the heat sink, respectively is provided. The first surface is disposed with an inlet port through which the coolant flows in and an outlet port through which the coolant flows out, and the second surface forms a return flow path of the coolant.

## Description

### CROSS-REFERENCE TO RELATED APPLICATIONS

The present application is a 371 National Stage entry of PCT/KR2024/007360 filed May 30, 2024, which claims the benefit of foreign priority to Korean Patent Application No. 10-2023-0071942, filed on June 02, 2023, all of which are incorporated by reference herein.

### TECHNICAL FIELD

The present disclosure relates to a heat sink assembly mounted to a bottom surface of a battery pack having a plurality of secondary batteries to facilitate heat dissipation of the battery pack.

### BACKGROUND

Secondary batteries, unlike primary batteries, are rechargeable and have been widely researched and developed in recent years due to the potential for miniaturization and large capacity. The demand for secondary batteries as an energy source is increasing rapidly due to the increasing technological development and demand for mobile devices, as well as electric vehicles and energy storage systems that are emerging in response to environmental protection needs.

Secondary batteries are categorized into coin type batteries, cylindrical batteries, prismatic batteries, and pouch type batteries according to the shape of the battery case. In a secondary battery, an electrode assembly mounted inside the battery case is a chargeable and dischargeable power generating device comprising a stacked structure of electrodes and separators.

Since secondary batteries are demanded to be used continuously for a long period of time, it is necessary to effectively control the heat generated during the charging and discharging process. If the secondary battery is not properly cooled, the increase in temperature will cause an increase in current, which will cause an increase in current, which will again cause an increase in temperature, which will cause a chain reaction, eventually leading to the catastrophic condition of thermal runaway.

In order to effectively release the heat generated by secondary batteries, heat sinks (also called cooling plates) through which coolant flows are widely used. The heat sink is mounted on the bottom surface of a group of secondary batteries, such as a battery pack mounting a plurality of secondary batteries and performs a cooling function by absorbing heat generated inside the pack with a coolant and releasing it to the outside.

Heat sinks can be divided into brazing heat sinks and extruded heat sinks according to their structure or manufacturing method. A brazing heat sink is a structure in which two plates are brazed together to form a flow path, which has a high degree of freedom in flow path design but has a disadvantage in structural rigidity due to material degradation. On the other hand, extruded heat sinks, which are manufactured as a continuum through extrusion molding, have an advantage in structural rigidity, but have the disadvantage that only straight flow paths can be realized, resulting in a large number of ports, and thus, pipes for connection take up space.

### SUMMARY

### [Technical Problem]

The present disclosure is directed to providing a heat sink assembly that is an extruded heat sink and does not require a separate pipe for flow path formation, thereby occupying less space, and can improve differential pressure by reducing the number of components with a simplified flow path configuration, and uniformly inducing a rate of flow of coolant flowing in a plurality of flow paths.

However, the technical problem to be solved by the present disclosure is not limited to the above-described problem, and other problems not mentioned can be clearly understood by a person skilled in the art from the description of the disclosure described below.

### [Technical Solution]

The present disclosure relates to a heat sink assembly includes a heat sink having a plurality of flow paths are integrally molded along an length direction by extrusion molding, the spaces between the flow paths forming a solid part, a first surface and a second surface of both ends in the length direction are opened, and both ends of the flow paths are spaced apart from the first surface and the second surface, and end plugs closing the opened first surface and second surface of both ends of the heat sink, respectively, wherein the first surface is disposed with an inlet port through which the coolant flows in and an outlet port through which the coolant flows out, and the second surface forms a return flow path of the coolant.

In one aspect of the present disclosure, an inlet flow path connected to the inlet port is disposed in a central region of the heat sink, and a pair of the outlet ports are provided such that the outlet flow paths connected to the outlet ports may be disposed on both sides of the inlet flow path.

The end plug may comprise an inlet plug closing a first surface of the inlet flow path, a pair of outlet plugs closing a first surface of the outlet flow path, and a return flow plug closing a second surface of the return flow path.

Meanwhile, the plurality of outlet flow paths may have a separation distance from the first surface that gradually decreases as the plurality of the outlet flow paths becomes closer to the inlet port.

For example, the plurality of outlet flow paths may have a separation distance from the first surface that decreases linearly as the plurality of outlet flow paths becomes closer to the outlet port.

The return flow path may have a constant separation distance from the second surface.

The plurality of outlet flow paths, wherein the pressure loss acting on the coolant flowing through the return flow path of the second surface to each of the plurality of outlet flow paths is proportional to the overall length of the outlet flow path, thereby uniformizing the rate of flow of the coolant flowing in each of the outlet flow paths.

In addition, in some aspects, an expanded solid part may be provided between the inlet flow path and the outlet flow path adjacent to the inlet flow path.

In the expanded solid part, the pack structures may be mechanically coupled.

In addition, a cross-sectional area in the length direction of the space between the inlet plug and the inlet flow path may be larger than a cross-sectional area in the length direction of the inlet flow path.

Further, the coolant flowing out from each of the pair of outlet ports may be joined into one by a pipe member.

### [Advantageous Effects]

The heat sink assembly of aspects of the present disclosure, having the configuration as described above, has excellent structural rigidity because the heat sink is manufactured as a continuum by extrusion molding, meanwhile, it can comprise a cooling passage divided into an inlet and an outlet by performing machining processing on both ends in the length direction of the flow path integrally formed in the heat sink and closing the open surface with an end plug.

Accordingly, the heat sink assembly of aspects of the present disclosure, while having an extruded heat sink as a basic framework which is advantageous in structural rigidity, occupies less space by not requiring a separate pipe for forming the flow path, can improve the differential pressure by reducing the number of components with a simplified flow path configuration, and can obtain stable cooling performance throughout the overall heat dissipating area by uniformly inducing the rate of flow of the coolant flowing in the plurality of flow paths.

However, the technical effects that can be obtained through the present disclosure is not limited to the above-described effects, and other effects not mentioned can be clearly understood by a person skilled in the art from the description of the disclosure described below.

### BRIEF DESCRIPTION OF THE DRAWINGS

Because the following drawings attached to the present specification illustrate exemplary aspects of the present disclosure and serve to facilitate understanding of the technical idea of the present disclosure together with the detailed description of the disclosure described below, the present disclosure should not be limitedly interpreted on the basis of the drawings.
FIG. 1 is a drawing illustrating a heat sink assembly according to one aspect of the present disclosure.
FIG. 2 is an exploded perspective view of the heat sink assembly of FIG. 1.
FIG. 3 is a drawing illustrating the structure of a heat sink in detail.
FIG. 4 is an enlarged view of "A" part of FIG. 1.
FIG. 5 is an enlarged view of the "B" part of FIG. 1.
FIG. 6 is a drawing illustrating overall coolant movement in the heat sink assembly of FIG. 1.
FIG. 7 is a drawing illustrating one example of pack structures coupling to the heat sink assembly of FIG. 1.
FIG. 8 is a drawing illustrating an aspect of a pair of outlet ports interconnected by a pipe member.

### DETAILED DESCRIPTION

References characters used in the present disclosure are as follows:
10: heat sink assembly
100: heat sink
110: flow path
112: inlet flow path
114: outlet flow path
116: return flow path
120: solid part
122: expanded solid part
124: screw hole
130: first surface
140: second surface
200: end plug
210: inlet plug
220: outlet plug
230: return flow plug
300: port
310: inlet port
320: outlet port
330: pipe member
400: pack structures
410: bolt
L: length direction
W: width direction

The present disclosure may have various modifications and various aspects, and thus specific aspects thereof will be described in detail below.

However, it should be understood that the present disclosure is not limited to the specific aspects, and includes all modifications, equivalents, or alternatives within the spirit and technical scope of the present disclosure.

The terms "comprise," "include," and "have" used herein designate the presence of characteristics, numbers, steps, actions, components, or members described in the specification or a combination thereof, and it should be understood that the possibility of the presence or addition of one or more other characteristics, numbers, steps, actions, components, members, or a combination thereof is not excluded in advance.

In addition, in the present disclosure, when a part of a layer, film, region, plate, or the like is disposed "on" another part, this includes not only a case in which one part is disposed "directly on" another part, but a case in which still another part is interposed therebetween. In contrast, when a part of a layer, film, region, plate, or the like is disposed "under" another part, this includes not only a case in which one part is disposed "directly under" another part, but a case in which still another part is interposed therebetween. In addition, in the present application, "on" may include not only a case of being disposed on an upper portion but also a case of being disposed on a lower portion.

The present disclosure relates to a heat sink assembly includes a heat sink having a plurality of flow paths are integrally molded along an length direction by extrusion molding, the spaces between the flow paths forming a solid part, a first surface and a second surface of both ends in the length direction are opened, and both ends of the flow paths are spaced apart from the first surface and the second surface, and end plugs closing the opened first surface and second surface of both ends of the heat sink, respectively, wherein the first surface is disposed with an inlet port through which the coolant flows in and an outlet port through which the coolant flows out, and the second surface forms a return flow path of the coolant.

The heat sink assembly of aspects of the present disclosure having the above configuration is manufactured as a continuum by extrusion molding to possess excellent structural rigidity, meanwhile, and comprise a cooling passage divided into an inlet and an outlet by performing machining processing on both ends in the length direction of the flow path integrally formed in the heat sink and closing the open surface with an end plug.

Accordingly, the heat sink assembly of aspects of the present disclosure, while having an extruded heat sink as a basic framework which is advantageous in structural rigidity, occupies less space by not requiring a separate pipe for forming the flow path, can improve differential pressure by reducing the number of components with a simplified flow path configuration.

Hereinafter, specific aspects of a heat sink assembly 10 according to the present disclosure will be described in detail with reference to the accompanying drawings. For reference, the directions of front, back, up, down, left, and right used in the following description to designate relative positions are for the purpose of understanding the disclosure and refer to the directions shown in the drawings unless otherwise specified.

### [first aspect]

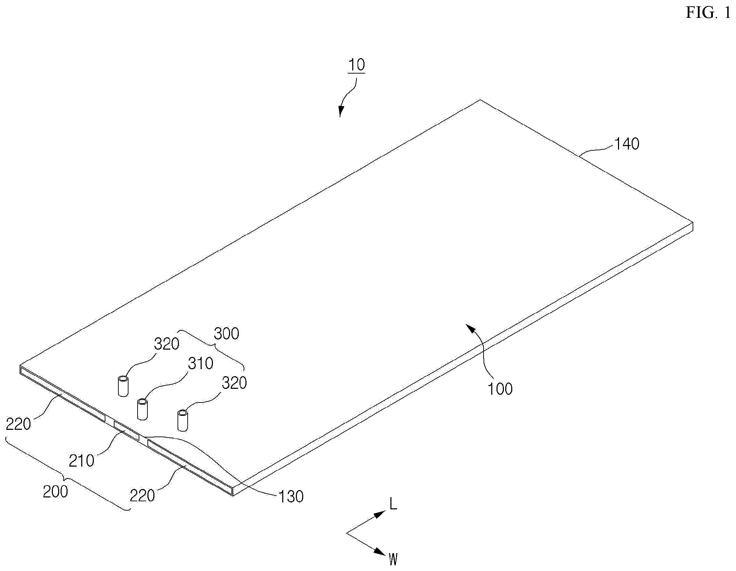

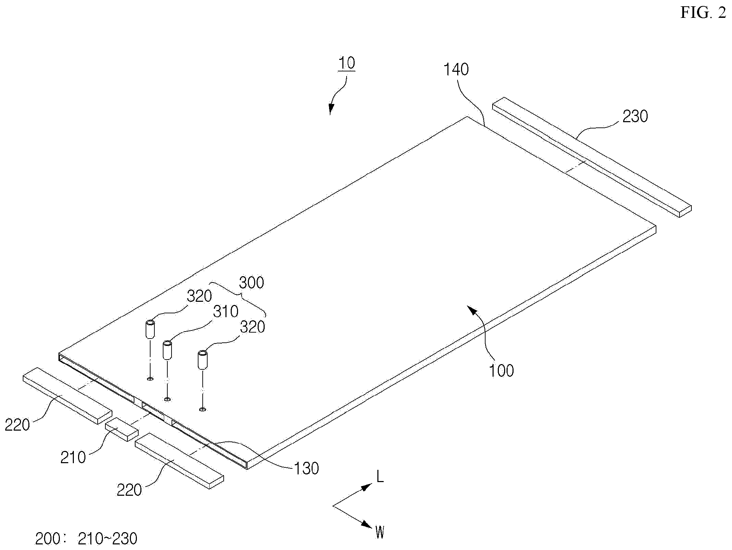

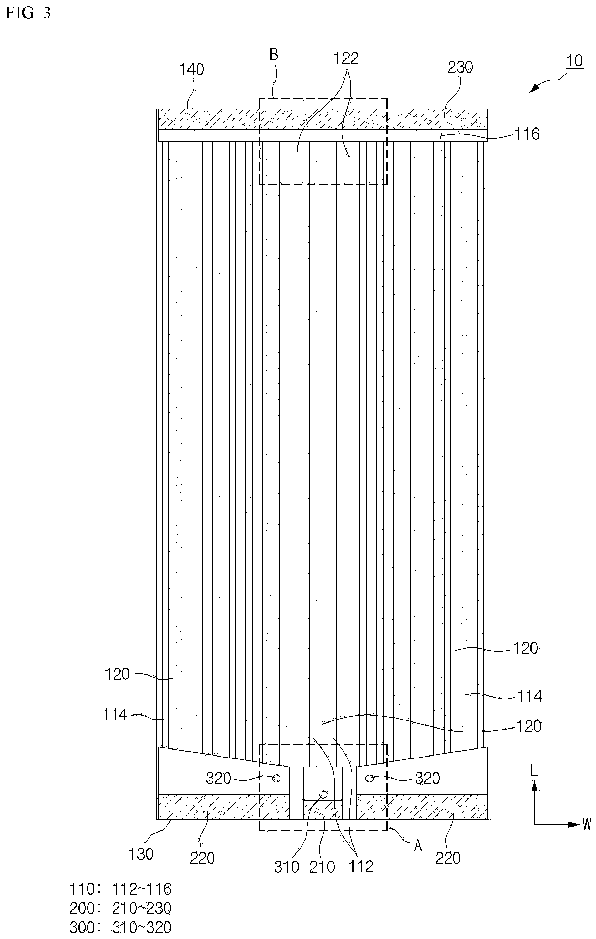

FIG. 1 is a drawing illustrating a heat sink assembly according to one aspect of the present disclosure, FIG. 2 is an exploded perspective view of the heat sink assembly of FIG. 1, and FIG. 3 is a drawing illustrating the structure of a heat sink in detail.

The heat sink assembly 10 of aspects of the present disclosure includes a heat sink 100 manufactured by extrusion molding, and a plurality of end plugs 200. The open surfaces of the heat sink 100 are surfaces on both ends in a length direction L. For ease of description, the two open surfaces will be referred to as a first surface 130 and a second surface 140, respectively. Here, the length direction L is defined as referring to the extrusion molding direction of the heat sink 100, in other words, the direction in which the plurality of flow paths 110 formed as hollow parts extend, and the width direction W is defined as referring to the direction in which the plurality of flow paths 110 are spaced apart and orthogonal to the length direction L on a plane.

The heat sink 100 is manufactured as an extrusion in which a plurality of flow paths 110 are integrally molded along an length direction L by extrusion molding. The plurality of flow paths 110 in which the coolant flows are hollow parts formed along the length direction L, and the space between the flow paths 110 forms a solid part 120. The first surface 130 and the second surface 140 on both ends in the length direction L of the heat sink 100 are opened because of the features of the extrusion molding.

In FIG. 3, the structure of the flow path 110 is illustrated in more detail. A plurality of flow paths 110 extending in a length direction L between the first surface 130 and the second surface 140, the ends of which are separated from the first surface 130 and the second surface 140 by a predetermined distance. The separation distance of the flow paths 110 from the first surface 130 and the second surface 140 can be freely designed by a cutting processing that removes the flow paths 110, which are hollow parts, and the solid part 120 therebetween. In addition, by removing the flow path 110 and the solid part 120 therebetween together, a depth in which the end plugs 200 are to be inserted is obtained.

The end plugs 200 close the opened first surface 130 and second surface 140 at both ends of the heat sink 100, respectively. The end plugs 200 have a thickness and width suitable for insertion into the openings on the first surface 130 and second surface 140 of the heat sink 100. The end plugs 200 inserted into the heat sink 100 may be sealed bonded by welding, for example, friction stir welding. If the welding depths of the friction stir welding performed on the upper and lower surfaces of the heat sink 100 are such that they overlap each other, a seal is completed by forming welding surfaces on up, down, left and right sides of the end plug 200.

Since the plurality of flow paths 110 extend in the length direction L, and the first surface 130 and second surface 140 are sealed with end plugs 200, the heat sink assembly 10 can be configured to enable the flow of coolant across the overall heat transfer area of the heat sink assembly 10 by appropriately selecting the positions of the ports 300 through which the coolant flows in and out. The present disclosure includes an inlet port 310 through which coolant flows in and an outlet port 320 through which coolant flows out on the first surface 130, and the ports 300 are disposed such that the second surface 140 forms a return flow path 116 for coolant without separate ports.

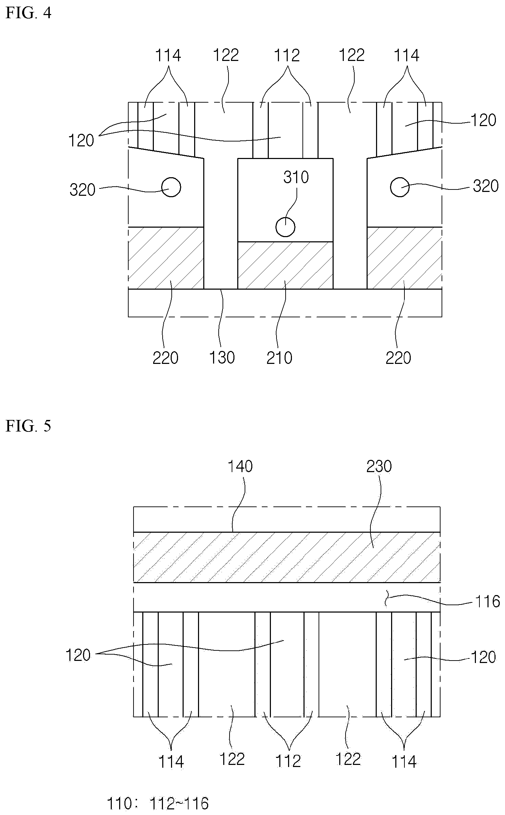

FIG. 4 is an enlarged view of "A" part of FIG. 1, examined in conjunction with FIG. 3, wherein an inlet flow path 112 connected to an inlet port 310 is disposed in a central region of the heat sink 100, a pair of outlet ports 320 are provided, and outlet flow paths 114 connected to the outlet ports 320 are disposed on both sides in the width direction W of the inlet flow path 112. In the illustrated aspect, two the inlet flow paths 112 are provided, and the terminals of the inlet flow path 112 are connected with a return flow path 116 elongated along the second surface 140, and the return flow path 116 is connected with the outlet flow paths 114 of both sides.

In one aspect of the present disclosure, the end plugs 200 closing the first surface 130 includes an inlet plug 210 closing the first surface 130 of the inlet flow path 112, and a pair of outlet plugs 220 closing the first surface 130 of the outlet flow path 114. A certain space is formed between the inlet plug 210 and the inlet flow path 112, and an inlet port 310 is disposed on this space. Accordingly, the coolant flowed in the inlet port 310 fills the space of the upstream side of the inlet flow path 112 and then diverges into each inlet flow path 112 and flows evenly. Similarly, an outlet port 320 is disposed in the space between the outlet plug 220 and the outlet flow path 114.

Moreover, the cross-sectional area in the length direction L of the space between the inlet plug 210 and the inlet flow path 112 may be larger than the overall cross-sectional area in the length direction L of the inlet flow path 112. The space between the inlet plug 210 and the inlet flow path 112 forming reservoir space, the flow of coolant introduced into the plurality of inlet flow paths 112 may be uniform and smooth.

FIG. 5 is an enlarged view of the "B" part of FIG. 1, illustrating a return flow path 116. The second surface 140 of the heat sink 100 is closed with a return flow plug 230, and the terminal of each flow path 110, in other words, the end of each flow path 110 facing the second surface 140, is also separated from the return flow plug 230 by a predetermined separation distance, and the space thus formed forms the return flow path 116. The return flow path 116 may be formed by the flow paths 110 having a constant separation distance from the second surface 140, in other words, without substantial change in cross-sectional area.

On the other hand, in one of the of the present disclosure, an end of each of the outlet flow paths 114, which directly connects to the outlet port 320, may be formed differently compared to the inlet flow path 112 or the return flow path 116. As illustrated in FIGS. 3 and 4, the plurality of outlet flow paths 114 may have a gradually decreasing separation distance from the first surface 130 as they become closer to the outlet port 320. For example, the plurality of outlet flow paths 114 may have a linearly decreasing separation distance from the first surface 130 as they become closer to the outlet port 320.

The heat sink assembly 10 of aspects of the present disclosure has an excessively large flow area occupied by the outlet flow path 114 compared to the flow area formed by the inlet flow path 112 and the return flow path 116. This is for the purpose that when the coolant is flowed in the heat sink 100, the flow velocity of the outlet flow path 114 is significantly reduced so that heat can be transferred for a sufficient time. On a different aspect, the flow rate distribution of the coolant is also most influenced by the outlet flow path 114

Because of the characteristics of the flow, the closer the outlet flow path 114 is to the inlet flow path 112, the lower the pressure loss until the coolant is flowed in, and because of this, the closer the outlet flow path 114 is to the inlet flow path 112, the more coolant tends to be introduced. Thus, in the illustrated heat sink assembly 10, the outlet flow paths 114 near the center tend to have a concentration of coolant, which results in lower heat transfer performance in the peripheral regions. If the cooling performance of the heat sink assembly 10 varies according to the region, localized high heat regions are more likely to occur, which adversely affects the performance of the battery pack. Such deviation in cooling performance can be solved by inducing a uniform rate of flow of coolant through each of the outlet flow paths 114.

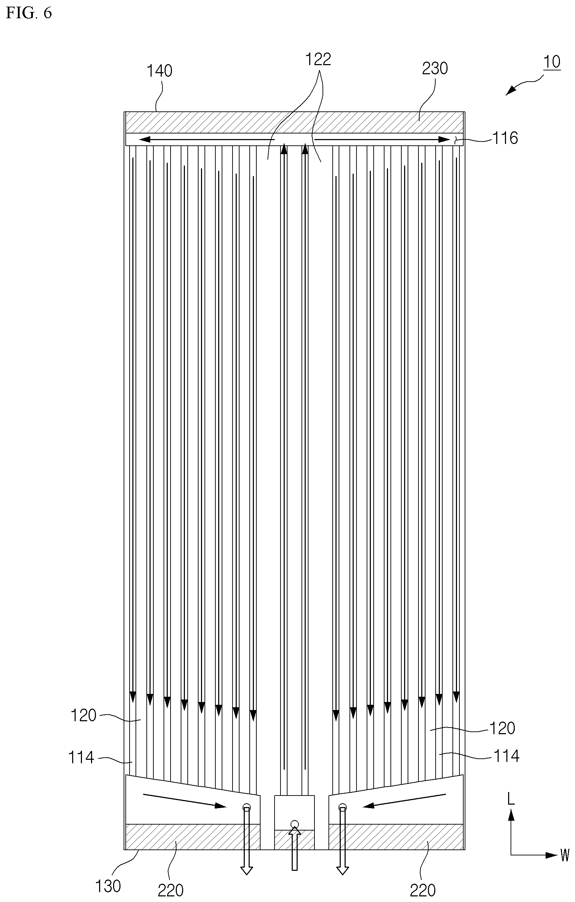

FIG. 6 is a drawing illustrating overall coolant movement in the heat sink assembly of FIG. 1. As described above, the plurality of outlet flow paths 114 has a shape such that the separation distance from the first surface 130 becomes gradually shorter as it becomes closer to the outlet port 320. In other words, the length of each of the plurality of outlet flow paths 114 becomes gradually longer as it becomes closer to the outlet port 320, in other words, as it becomes closer to the inlet flow path 112. In each outlet flow path 114, the pressure loss acting on the coolant is proportional to the length of each outlet flow path 114 forming a boundary layer with the fluid. Thus, since the pressure loss acting on the coolant flowing through the return flow path 116 of the second surface 140 into each outlet flow path 114 is proportional to the overall length of the outlet flow path 114, the rate of flow of the coolant gradually increases toward the outlet flow path 114 on the outer side surface, and as a result, when the outlet flow path 114 is closer to the inlet flow path 112, the characteristics of more coolant being introduced are offset, resulting in a uniform rate of flow of the coolant flowing through each outlet flow path 114.

As described above, the heat sink assembly 10 according to an aspect of the present disclosure enables the coolant to flow at a uniform rate of flow across the overall area of the heat sink 100, thereby exhibiting uniform cooling characteristics that are not concentrated in a particular region.

### [second aspect]

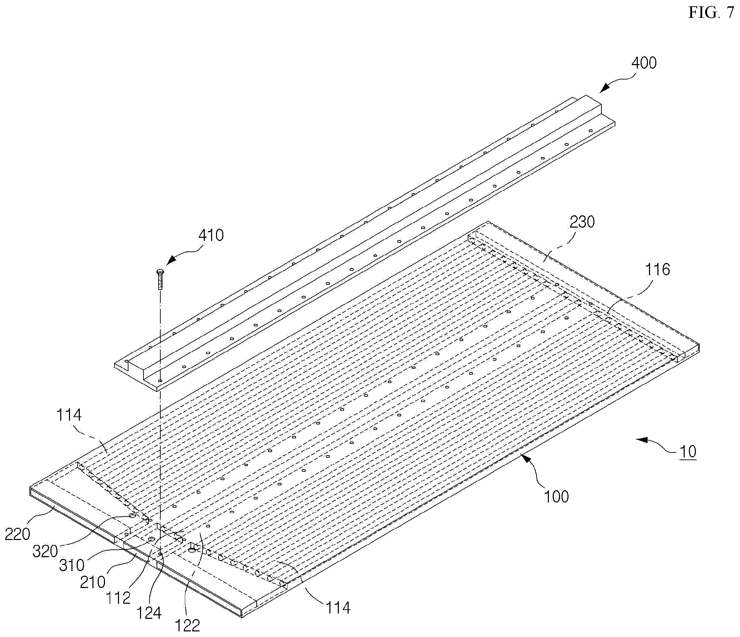

FIG. 7 is a drawing illustrating one example of pack structures coupling to the heat sink assembly of FIG. 1. Referring to FIGS. 1 to 5 together, an expanded solid part 122 is provided between the inlet flow path 112 and the outlet flow path 114 adjacent to the inlet flow path 112. Here, the expanded solid part 122 refers to a solid part 122 having a larger width compared to, for example, the solid part 120 comprising the space between the flow paths 110. For example, the expanded solid part 122 can be formed by forming a solid part with a width that skipped a space of about one flow path between the inlet flow path 112 and the outlet flow path 114.

As illustrated in FIG. 3 and FIG. 6, a flow path 110 is formed across nearly the entire of the heat sink 100, and therefore, in order to couple the heat sink assembly 10 of aspects of the present disclosure to the battery pack, it is necessary to provide a coupling structure capable of maintaining sufficient mechanical strength without damaging the flow path 110. For this, an expanded solid part 122 is provided along the center length direction L of the heat sink assembly 10.

For example, as shown in FIG. 7, a plurality of screw holes 124 may be processed along the expanded solid part 122, above which pack structures 400 (e.g., a center frame) may be firmly coupled to the heat sink assembly 10 by bolts 410 that are engaged to the screw holes 124.

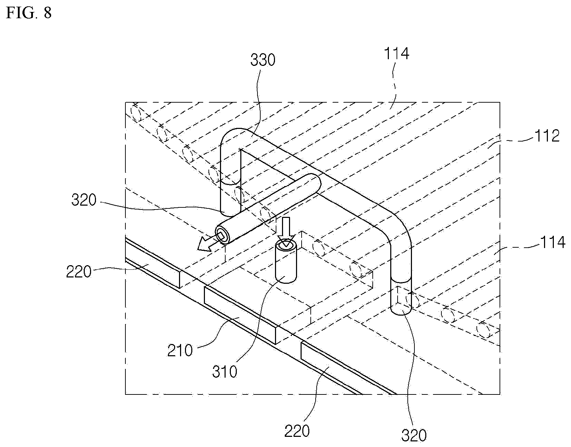

FIG. 8 is a drawing illustrating an aspect of a pair of outlet ports interconnected by a pipe member.

The present disclosure comprises two outlet ports 320 in the flow path structure. Therefore, two external pipes connecting to the outlet ports 320 are needed, but by connecting the pair of outlet ports 320 with the pipe member 330 in the shape of the letter "Y" or "T", as shown in FIG. 8, the coolant flowing in two streams can be joined into one. By the pipe member 330 joining the two outlet ports 320 into one, the external pipe structure comprising the heat sink assembly 10 is more simplified.

As aforementioned, the present disclosure has been described in more detail through the drawings and aspects. However, since the configuration described in the drawings or aspects described herein is merely one aspect of the present disclosure and do not represent the overall technical spirit of the disclosure, it should be understood that the disclosure covers various equivalents, modifications, and substitutions at the time of filing of this application.

## Claims

1. A heat sink assembly comprising: a heat sink having a plurality of flow paths integrally formed along an length direction, spaces between the plurality of flow paths forming a solid part, a first surface and a second surface of both ends in the length direction are opened, and both ends of the plurality of flow paths are spaced apart from the first surface and the second surface; and
end plugs closing the opened first surface and second surface of both ends of the heat sink, respectively,
wherein the first surface is disposed adjacent an inlet port configured to received coolant flow in and an outlet port configured for coolant flow out,
wherein the second surface forms a return flow path for coolant.

2. The heat sink assembly of claim 1, wherein the plurality of flow paths comprise an inlet flow paths and a plurality of outlet flow paths,
the inlet flow path is connected to the inlet port and disposed in a central region of the heat sink,
and the outlet port is one of a pair of outlet ports provided such that the plurality of outlet flow paths connected to the pair of outlet ports are disposed on both sides of the inlet flow path.

3. The heat sink assembly of claim 2, wherein the end plugs includes an inlet plug closing the first surface having the inlet flow path,
a pair of outlet plugs closing the first surface having the plurality of outlet flow paths, and
a return flow plug closing the second surface having the return flow path.

4. The heat sink assembly of claim 2, wherein the plurality of outlet flow paths has a separation distance from the first surface that gradually decreases as the plurality of the outlet flow paths becomes closer to the outlet port.

5. The heat sink assembly of claim 4, wherein the plurality of outlet flow paths has a separation distance from the first surface that decreases linearly as the plurality of outlet flow paths becomes closer to the outlet port.

6. The heat sink assembly of claim 4, wherein the return flow path has a constant separation distance from the second surface.

7. The heat sink assembly of claim 6, wherein pressure loss acting on coolant flowing through the return flow path of the second surface to each of the plurality of outlet flow paths is proportional to the overall length of the outlet flow path.

8. The heat sink assembly of claim 2, wherein an expanded solid part is provided between the inlet flow path and the outlet flow path adjacent to the inlet flow path.

9. The heat sink assembly of claim 8, wherein in the expanded solid part is configured to mechanically couple to pack structures.

10. The heat sink assembly of claim 3, wherein a cross-sectional area in the length direction of a space between the inlet plug and the inlet flow path is larger than a cross-sectional area in the length direction of the inlet flow path.

11. The heat sink assembly of claim 2, further comprising a pipe member, wherein coolant flowing out from each of the pair of outlet ports is joined into one by the pipe member.
